**Europäisches Patentamt**

(19) **European Patent Office**

**Office européen des brevets**

(11) Publication number : **0 343 936 B1**

(12) **EUROPEAN PATENT SPECIFICATION**

(45) Date of publication of patent specification :
02.12.92 Bulletin 92/49

(51) Int. Cl.⁵ : **H01L 23/10, H01L 23/46**

(21) Application number : **89305218.3**

(22) Date of filing : **23.05.89**

(54) **Module sealing structure.**

(30) Priority : **24.05.88 JP 125023/88**

(43) Date of publication of application :
**29.11.89 Bulletin 89/48**

(45) Publication of the grant of the patent :
**02.12.92 Bulletin 92/49**

(84) Designated Contracting States :
**DE FR GB**

(56) References cited :
**EP-A- 0 001 123**
**IBM Technical Disclosure Bulletin, vol. 20, no.
9, february 1978, page 3446, New York, US; A.
Rifkin et al.: "Sealant forsemiconductor pack-
age"**
**IBM Technical Disclosure Bulletin, vol. 20, no.
8, january 1978, pages 3085-3086, New York,
US; J .FRANCIS et al.: "Forming ahermetic
bond in semiconductor package"**
**IBM Technical Disclosure Bulletin, vol. 28, no.
1, june 1985, pages 219-220, New York, US;
"Mechanically-sealed circuitmodule con-
struction"**

(56) References cited :
**IBM Technical Disclosure Bulletin, vol. 30, no.
11, april 1988, pages 45-56, New York, US;
"Alternate sealing approach forTCM-type
modules"**
**IBM Technical Disclosure Bulletin, vol. 26, no.
12, may 1984, pages 6297-6298, New York, US;
S. Chiang: "Baseplate design fordirect seal"**
**PATENT ABSTRACTS OF JAPAN, vol. 8, no.
131 (E-251), 19.6.1984; & JP-A-59 41 857**

(73) Proprietor : **FUJITSU LIMITED**
**1015, Kamikodanaka Nakahara-ku**
**Kawasaki-shi Kanagawa 211 (JP)**

(72) Inventor : **Moriizumi, Kiyokazu**
**4-7-33-105, Suge Tama-ku**
**Kawasaki-shi Kanagawa, 214 (JP)**
Inventor : **Kawano, Kyoichiro**
**30-1A-33, Enokigaoka Midori-ku**
**Yokohama-shi Kanagawa, 227 (JP)**
Inventor : **Seyama, Kiyotaka**
**2-50-1, Minamisaiwaicho Sawai-ku**
**Kawasaki-shi Kanagawa, 210 (JP)**

(74) Representative : **Stebbing, Timothy Charles et
al**
**Haseltine Lake & Co. Hazlitt House 28**
**Southampton Buildings Chancery Lane**
**London WC2A 1AT (GB)**

EP 0 343 936 B1

## Description

The present invention generally relates to module sealing structures, and more particularly to a module sealing structure for sealing a module which has plated printed circuits provided with a thermal conduction type cooling system.

Recently, a plated printed circuit of an electronic apparatus such as a computer generates a large quantity of heat because a large number of integrated circuit elements is provided on a multilayer ceramic substrate with a high density and the circuits are operated at a high speed. Accordingly, the plated printed circuit must be effectively cooled in order to ensure a stable operation of the circuits. Usually, a thermal conduction type cooling system is employed in which each of the integrated circuit elements are directly cooled by use of a cooling medium having a large cooling effect.

According to the thermal conduction type cooling system, a cold plate having a passage through which a cooling medium flows and bellows which communicate to the passage is arranged immediately above the integrated circuit elements at the surface of the plated printed circuit and an ambient atmosphere becomes highly humid. For this reason, a space between the cold plate and the plated printed circuit is sealed and a gas such as nitrogen and helium is sealed within the space with a predetermined pressure so as to maintain a dry atmosphere. This sealing structure prevents the corrosion of the integrated circuit elements, the circuit patterns and the bonding material, and the reliability of the plated printed circuit is prevented from becoming deteriorated.

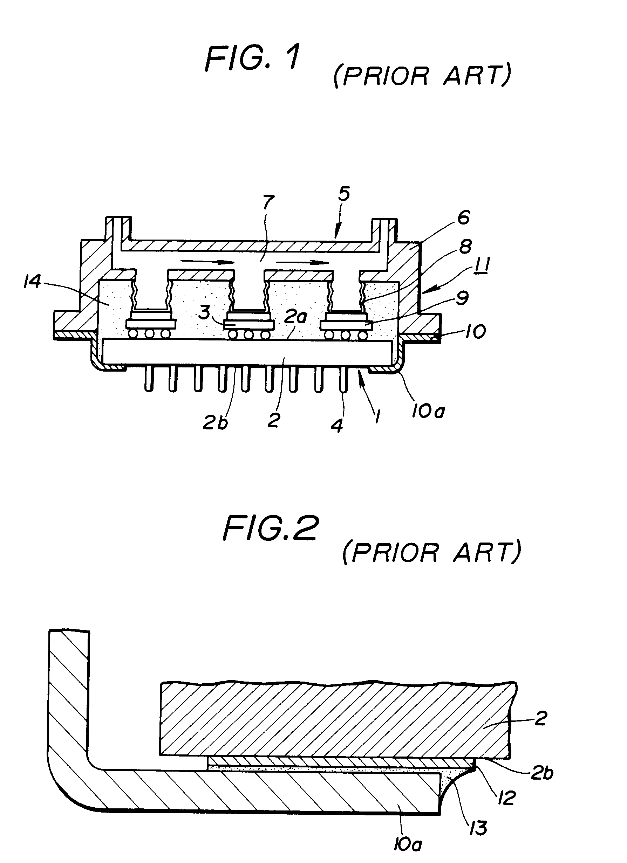

FIG.1 shows an example of a conventional module sealing structure, and FIG.2 shows an essential part of the conventional module sealing structure on an enlarged scale. In FIG.1, a plated printed circuit 1 has a multi-layer ceramic substrate 2 having a top surface 2a and a bottom surface 2b. A large number of integrated circuit elements 3 are provided on the top surface 2a of the substrate 2, and input/output pins 4 project from the bottom surface 2b of the substrate 2. A thermal conduction type cooling system 5 includes a box shaped cold plate 6 which opens to the bottom. A passage 7 for the cooling medium is provided inside the cold plate 6, and bellows 8 communicate to the passage 7. The cold plate 6 is arranged so that a bottom plate portion 9 of each of the bellows 8 make close adherence with the corresponding integrated circuit element 3 of the plated printed circuit 1, and a generally ring-shaped metal fitting 10 is mounted at the bottom of the cold plate 6. A flange 10a of the metal fitting 10 projects inwardly thereto and holds the peripheral portion of the bottom surface 2b of the substrate 2. A module 11 is completed in this manner.

The sealing between the bottom surface 2b of the substrate 2 and the flange 10a of the metal fitting 10 is made as shown in FIG.2. That is, a thin metal film 12 is formed on the peripheral portion of the bottom surface 2b of the substrate 2, and this thin metal film 12 and the flange 10a are fixed by a solder 13 to provide the sealing between the bottom surface 2b of the substrate 2 and the flange 10a of the metal fitting 10. As a result, a sealed space 14 is formed between the cold plate 6 and the plated printed circuit 1, and a gas such as nitrogen is sealed within the space 14.

Therefore, the integrated circuit elements 3, the circuit patterns on the substrate 2 and the like are maintained in a dry atmosphere by the sealed gas within the space 14, and the heat generated from the integrated circuit elements 3 is reduced and eliminated by the cooling medium in the bellows 8.

In the conventional module sealing structure, the sealing is made by directly fixing the flange 10a to the thin metal layer 12 which is formed on the peripheral portion of the bottom surface 2b of the substrate 2 by the solder 13. For this reason, a pushing force exerted by the bellows 8 acts directly on the junction between the peripheral portion of the substrate 2 and the flange 10a. In addition, a thermal stress is generated at the junction due to differences in the coefficients of thermal expansion of the materials used at the junction, but there is no means for absorbing the thermal stress. As a result, damage such as cracking easily occurs at the junction, and the substrate 2 is easily damaged because it is usually made of glass ceramics or the like which is mechanically weak.

A module sealing structure of a similar construction is shown in EP-A-0 001 123. No details of the sealing arrangement are given in this document.

According to the present invention, there is provided a module sealing structure comprising a cold plate having a passage through which a cooling medium flows, bellows having first ends which communicate to the passage in said cold plate, said cold plate and said bellows forming a thermal conduction type cooling system, a plated printed circuit having a substrate and integrated circuit elements provided on a first surface of the substrate, said integrated circuit elements being in contact with second ends of said bellows, and a metal fitting secured on said cold plate and having a flange for catching a second surface of the substrate at a junction between the second surface of the substrate and the flange of said metal fitting, said substrate, said cold plate and said metal fitting forming a sealed space above said integrated circuit elements, characterised in that said substrate has a polyimide layer formed on the second surface thereof and a conductor layer formed on the polyimide layer, said polyimide layer and said conductor layer being respectively formed in an approximate ring shape at least in a peripheral portion of the second surface of said substrate, said polyimide layer having at least one groove which is formed in an approximate ring shape so that said conductor layer makes direct contact with the second surface of said substrate at the groove; and the flange of said metal fitting being fixed to the second surface of said substrate by a solder which is provided between the conductor layer and the flange, thereby providing a seal between said substrate and the flange.

According to the module sealing structure of the present invention, it is possible to absorb the excessive force acting on the substrate from the bellows and also absorb the thermal stress generated at the junction by the provision of the polyimide layer. As a result, it is possible to prevent damage at the junction and to the substrate itself, and provide a positive seal between the substrate and the metal fitting.

Reference is made, by way of example, to the accompanying drawings in which:

Fig. 1 is a cross sectional view generally showing an example of a conventional module sealing structure;

Fig. 2 is a cross sectional view on an enlarged scale showing an essential part of the conventional module sealing structure shown in Fig. 1;

Fig. 3 is a cross sectional view generally showing an embodiment of a module sealing structure according to the present invention;

Fig. 4 is a bottom view generally showing the embodiment shown in Fig. 3;

Fig. 5 is a side view on an enlarged scale showing an essential part of the embodiment shown in FIG.3;

FIGS.6A through 6E are cross sectional views of the embodiment shown in FIG.3 at different production stages thereof; and

FIG.7 is a cross sectional view on an enlarged scale showing an essential part of another embodiment of the module sealing structure according to the present invention.

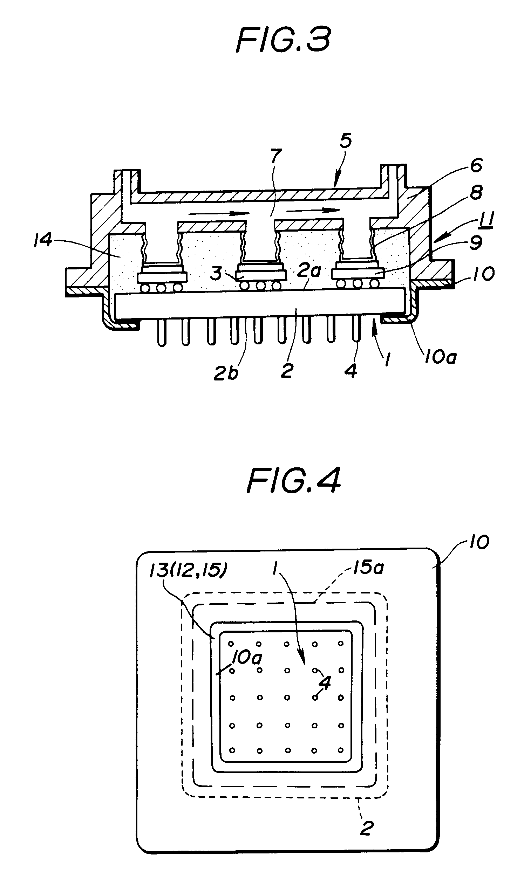

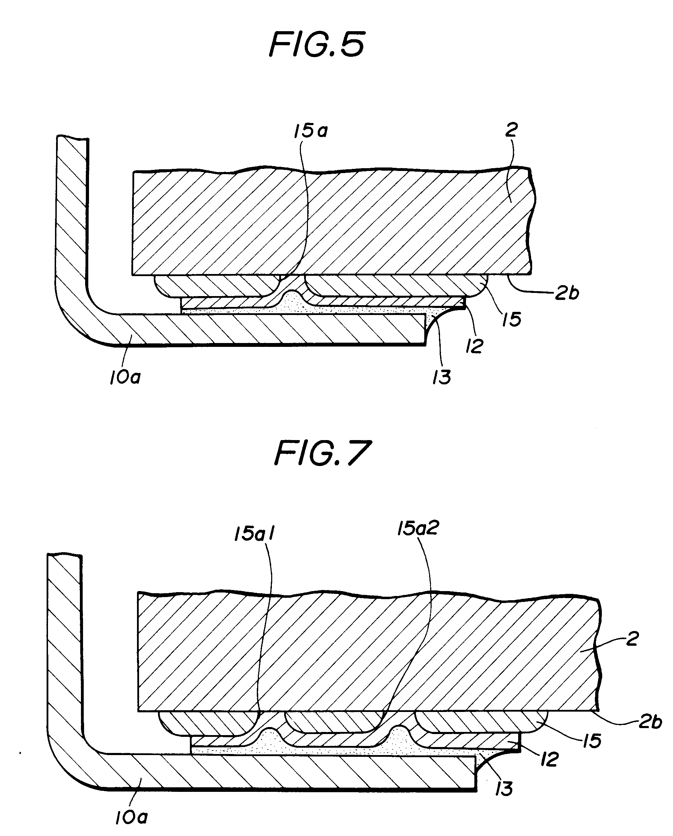

FIGS.3 and 4 respectively show an embodiment of a module sealing structure according to the present invention in a cross section and a bottom view, and FIG.5 shows an essential part of the embodiment in a cross section on an enlarged scale. In FIGS.3 through 5, those parts which are substantially the same as those corresponding parts in FIGS.1 and 2 are designated by the same reference numerals, and a description thereof will be omitted.

In FIGS.3 through 5, the plated printed circuit 1 and the thermal conduction type cooling system 5 are identical to those shown in FIGS.1 and 2 described before. However, in this embodiment, a junction between the peripheral portion of the bottom surface 2b of the substrate 2 and the flange 10a of the generally rectangular ring-shaped metal fitting 10 is different from that shown in FIGS.1 and 2. As may be seen from FIG.5, a polyimide layer 15 is formed on the peripheral portion of the bottom surface 2b of the substrate 2, and the thin metal film 12 is formed on the polyimide layer 15. A groove 15a is formed in the polyimide layer 15 and the thin metal film 12 is also formed within the groove 15a to make contact with the bottom surface 2b of the substrate 2. The sealing is made by fixing the flange 10a to the thin metal film 12 by the solder 13.

The thin metal film 12 on the bottom surface 2b of the substrate 2 strongly adheres to the polyimide layer 15, and for this reason, the substrate 2 strongly adheres on the flange 10a of the metal fitting 10. On the other hand, the polyimide layer 15 is resilient. Hence, the pushing force exerted by the bellows 8 can be distributed over approximately the entire polyimide layer 15 due to the deformation of the polyimide layer 15. Furthermore, the thermal stress generated at the junction is similarly absorbed by the deformation of the polyimide layer 15. Therefore, no excess force acts on the substrate 2 and it is possible to prevent a damage at both the junction and the substrate 2 itself.

The polyimide layer 15 absorbs moisture but the external moisture is prevented from reaching the top surface 2a of the substrate 2 by the thin metal film 12 which is formed on the polyimide layer 15 and inside the groove 15a. Hence, the top surface 2a of the substrate 2 is positively maintained to the dry atmosphere.

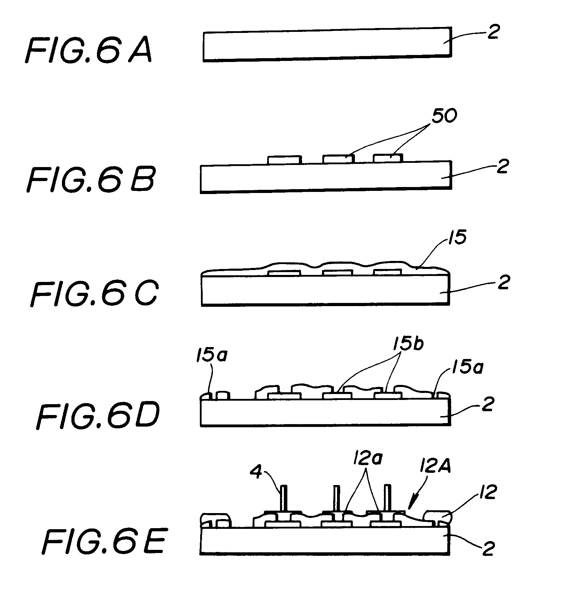

Next, a description will be given of an embodiment of a method of producing the module sealing structure shown in FIGS.3 through 5, by referring to FIGS.6A through 6E. The substrate 2 shown in FIG.6A is a multi-layer ceramic substrate, and circuit patterns 50 made of a conductor are formed on the bottom surface 2b of the substrate 2 by a known process as shown in FIG.6B. Then, a photosensitive polyimide layer 15 is formed on the bottom surface 2b of the substrate 2 to an approximately uniform thickness as shown in FIG.6C by a known spin-coating process for use as an insulator layer, and the photosensitive polyimide layer 15A is patterned by a known exposure and developing process. The groove 15a and holes 15b are formed in the photosensitive polyimide layer 15 as shown in FIG.6D by the exposure and developing process which hardens only the exposed portions of the photosensitive polyimide layer 15. Finally, a conductor pattern layer 12A including the thin metal film 12 and input/output patterns 12a are simultaneously formed on the remaining polyimide layer 15 by a known patterning process, and the input/output pins 4 are formed on the input/output patterns 12a. The groove 15a and the holes 15b may be formed by an etching process, and the conductor pattern layer 12A may be formed uniformly by a sputtering process.

The metal fitting 10 is secured on the cold plate 6 by screws (not shown), for example. In this case, an O-ring (not shown) is provided between the metal fitting 10 and the cold plate 6. The flange 10a of the metal fitting 10 is fixed on the thin metal film 12 of the plated printed circuit 1 shown in FIG.6E by the solder 13.

The present inventors have compared the conventional structure shown in FIG.2 with the structure of the embodiment shown in FIG.5 for strength at the junction between the flange 10a of the metal fitting 10 and the bottom surface 2b of the substrate 2, and tests have shown that the strength of the junction obtainable by the structure shown in FIG.5 is approximately two times that obtainable by the conventional structure shown in FIG.2. For example, in a case where the area of adhesion at the junction is approximately 100mm x 100mm and the pull strength along a direction perpendicular to the area of adhesion is approximately 2 mm/min, a maximum strength of the junction constituted by the substrate 2, the thin metal film 12, the solder 13 and the flange 10a shown in FIG.2 is approximately 55 kg while a maximum strength of the junction constituted by the substrate 2, the polyimide layer 15, the thin metal film 12, the solder 13 and the flange 10a shown in FIG.5 is approximately 110 kg.

Next, a description will be given of another embodiment of the module sealing structure according to the present invention, by referring to FIG.7. In FIG.7, those parts which are the same as those corresponding parts in FIGS.3 through 5 are designated by the same reference numerals, and a description thereof will be omitted. In this embodiment, two grooves 15a1 and 15a2 are formed in the polyimide layer 15 to provide a more positive moisture seal. According to this embodiment, the adhesion area of the solder 13 is increased thereby improving the strength at the junction between the substrate 2 and the flange 10a of the metal fitting 10. It is of course possible to provide more than two grooves 15a in the polyimide layer 15.

The substrate 2 is not limited to the multi-layer ceramic substrate, and other substrates such as a glass ceramic substrate may be used.

Further, the present invention is not limited to these embodiments, but various variations and modifications may be made without departing from the scope of the present invention.

**Claims**

1. A module sealing structure comprising a cold plate (6) having a passage (7) through which a cooling medium flows, bellows (8) having first ends which communicate to the passage in said cold plate, said cold plate and said bellows forming a thermal conduction type cooling system (5), a plated printed circuit (1) having a substrate (2) and integrated circuit elements (3) provided on a first surface (2a) of the substrate (2), said integrated circuit elements (3) being in contact with second ends of said bellows (8), and a metal fitting (10) secured on said cold plate (6) and having a flange (10a) for catching a second surface (2b) of the substrate at a junction between the second surface (2b) of the substrate and the flange (10a) of said metal fitting, said substrate (2), said cold plate (6) and said metal fitting (10) forming a sealed space (14) above said integrated circuit elements (3), therein said substrate (2) has a polyimide layer (15) formed on the second surface (2b) thereof and a conductor layer (12) formed on the polyimide layer (15), said polyimide layer (15) and said conductor layer (12) are respectively formed in an approximate ring shape at least in a peripheral portion of the second surface (2b) of said substrate, said polyimide layer (15) having at least one groove (15a, 15a1, 15a2) which is formed in an approximate ring shape so that said conductor layer (12) makes direct contact with the second surface (2b) of said substrate at the groove, and the flange (10a) of said metal fitting (10) is fixed to the second surface (2b) of said substrate by a solder (13) which is provided between the conductor layer (12) and the flange (10a), thereby providing a seal between said substrate and the flange.

2. The module sealing structure as claimed in claim 1, characterized in that said sealed space (14) between said cold plate (6) and said substrate (2) and said metal fitting (10), is fitted by a predetermined gas selected from a group including nitrogen and helium.

3. The module sealing structure as claimed in claim 1 or 2, characterized in that said substrate (2) has circuit patterns (50) formed on the second surface (2b) thereof, and said conductor layer (12) is made of a metal layer identical to a metal layer constituting the circuit patterns.

4. The module sealing structure as claimed in claim 3, characterized in that an insulator layer (15) is formed on said circuit patterns (50), and said insulator layer is constituted by said polyimide layer (15).

5. The module sealing structure as claimed in claim 4, characterized in that said substrate (2) further has input/output patterns (12a) formed on said insulator layer (15) and connecting to said circuit patterns (50) via holes formed in said insulator layer, and input/output pins (4) which connect to said circuit patterns.

6. The module sealing structure as claimed in any of claims 1 to 5, characterized in that said substrate (2) is made of a ceramic.

7. The module sealing structure as claimed in any of claims 1 to 5, characterized in that said substrate (2) is a multi-layer ceramic substrate.

8. The module sealing structure as claimed in any of claims 1 to 5, characterized in that said substrate (2) is a glass ceramic substrate.

9. The module sealing structure as claimed in any of claims 1 to 7, characterized in that said metal fitting (10) has a generally rectangular ring shape in correspondence with a shape of said substrate (2).

**Patentansprüche**

1. Eine Modulversiegelungsstruktur mit einer Kühlplatte (6) mit einem Durchgang (7), durch den ein Kühlmedium fließt, Balgen (8) mit ersten Enden, die mit dem Durchgang in der genannten Kühlplatte kommunizieren, welche Kühlplatte und Balgen ein Kühlsystem des Wärmeleitungstyps (5) bilden, einer plattiert gedruckten Schaltung (1) mit einem Substrat (2) und integrierten Schaltungselementen (3), die auf einer ersten Oberfläche (2a) des Substrats (2) vorgesehen sind, welche integrierten Schaltungselemente (3) mit zweiten Enden der genannten Balgen (8) in Kontakt sind, und einem Metallpaßstück (10), das auf der genannten Kühlplatte (6) gesichert ist und einen Flansch (10a) zum Halten einer zweiten Oberfläche (2b) des Substrats an einer Verbindungsstelle zwischen der zweiten Oberfläche (2b) des Substrats und des Flansches (10a) des genannten Metallpaßstückes hat, wobei das genannte Substrat (2), die genannte Kühlplatte (6) und das genannte Metallpaßstück (10) einen versiegelten Raum (14) über den genannten integrierten Schaltungselementen (3) bilden, bei der das genannte Substrat (2) eine Polyimidschicht (15) hat, die auf der zweiten Oberfläche (2b) davon gebildet ist, und eine Leiterschicht (12), die auf der Polyimidschicht (15) gebildet ist, welche Polyimidschicht (15) und Leiterschicht (12) wenigstens an einem Randteil der zweiten Oberfläche (2b) des genannten Substrats jeweils nahezu ringförmig gebildet sind, welche Polyimidschicht (15) wenigstens eine Nut (15a, 15a1, 15a2) hat, die nahezu ringförmig gebildet ist, so daß die genannte Leiterschicht (12) in der Nut mit der zweiten Oberfläche (2b) des genannten Substrats in direktem Kontakt ist, und der Flansch (10a) des genannten Metallpaßstückes (10) an der zweiten Oberfläche (2b) des genannten Substrats durch ein Lötmittel (13) befestigt ist, das zwischen der Leiterschicht (12) und dem Flansch (10a) vorgesehen ist, wodurch eine Versiegelung zwischen dem genannten Substrat und dem Flansch realisiert wird.

2. Die Modulversiegelungsstruktur nach Anspruch 1, dadurch gekennzeichnet, daß der genannte versiegelte Raum (14) zwischen der genannten Kühlplatte (6) und dem genannten Substrat (2) und dem genannten Metallpaßstück (10) mit einem vorbestimmten Gas gefüllt ist, das aus der Gruppe bestehend aus Stickstoff und Helium ausgewählt wird.

3. Die Modulversiegelungsstruktur nach Anspruch 1 oder 2, dadurch gekennzeichnet, daß das genannte Substrat (2) Schaltungsmuster (50) hat, die auf der zweiten Oberfläche (2b) davon gebildet sind, und die genannte Leiterschicht (12) aus einer Metallschicht besteht, die mit einer Metallschicht identisch ist, die die Schaltungsmuster bildet.

4. Die Modulversiegelungsstruktur nach Anspruch 3, dadurch gekennzeichnet, daß eine Isolierschicht (15) auf den genannten Schaltungsmustern (50) gebildet ist, und die genannte Isolierschicht durch die genannte Polyimidschicht (15) gebildet ist.

5. Die Modulversiegelungsstruktur nach Anspruch 4, dadurch gekennzeichnet, daß das genannte Substrat (2) ferner Eingangs-/Ausgangsmuster (12a) hat, die auf der genannten Isolierschicht (15) gebildet sind und mit den genannten Schaltungsmustern (50) über Löcher verbunden sind, die in der genannten Isolierschicht gebildet sind, und Eingangs/Ausgangsanschlüsse (4), die mit den genannten Schaltungsmustern verbunden sind.

6. Die Modulversiegelungsstruktur nach irgendeinem der Ansprüche 1 bis 5, dadurch gekennzeichnet, daß das genannte Substrat (2) aus Keramik besteht.

7. Die Modulversiegelungsstruktur nach irgendeinem der Ansprüche 1 bis 5, dadurch gekennzeichnet, daß das genannte Substrat (2) ein Mehrschicht-Keramiksubstrat ist.

8. Die Modulversiegelungsstruktur nach irgendeinem der Ansprüche 1 bis 5, dadurch gekennzeichnet, daß das genannte Substrat (2) ein Glaskeramiksubstrat ist.

9. Die Modulversiegelungsstruktur nach irgendeinem der Ansprüche 1 bis 7, dadurch gekennzeichnet, daß das genannte Metallpaßstück (10) eine im allgemeinen rechtwinklige Ringform hat, entsprechend einer Form des genannten Substrats (2).

**Revendications**

1.  Structure de scellage de module comprenant : une plaque froide (6) qui comporte un passage (7) au travers duquel un milieu de refroidissement s'écoule, des soufflets (8) qui comportent des premières extrémités qui communiquent avec le passage ménagé dans ladite plaque froide, ladite plaque froide et lesdits soufflets formant un système de refroidissement (5) du type à conduction thermique, un circuit imprimé en forme de plaque (1) qui comporte un substrat (2) et des éléments de circuit intégré (3) installés sur une première surface (2a) du substrat (2), lesdits éléments de circuit intégré (3) étant en contact avec des secondes extrémités desdits soufflets (8), et un raccord en métal (10) qui est fixé sur ladite plaque froide (6) et qui comporte un flanc (10a) pour tenir une seconde surface (2b) du substrat au niveau d'une jonction entre la seconde surface (2b) du substrat et le flanc (10a) dudit raccord en métal, ledit substrat (2), ladite plaque froide (6) et ledit raccord en métal (10) formant un espace scellé (14) au-dessus desdits éléments de circuit intégré (3), dans lequel ledit substrat (2) comporte une couche en polyimide (15) formée sur sa seconde surface (2b) et une couche conductrice (12) formée sur la couche de polyimide (15), ladite couche de polyimide (15) et ladite couche conductrice (12) étant respectivement formées selon une forme approximative d'anneau au moins dans une partie périphérique de la seconde surface (2b) dudit substrat, ladite couche de polyimide (15) comportant au moins une gorge (15a, 15a1, 15a2) qui est formée selon une forme approximative d'anneau de telle sorte que ladite couche conductrice (12) établisse un contact direct avec la seconde surface (2b) dudit substrat au niveau de la gorge ; et le flanc (10a) dudit raccord en métal (10) est fixé à la seconde surface (2b) dudit substrat au moyen d'une soudure (13) qui est placée entre la couche conductrice (12) et le flanc (10a) et ainsi, le scellage entre ledit substrat et le flanc est assuré.

2.  Structure de scellage de module selon la revendication 1, caractérisé en ce que ledit espace scellé (14) est situé entre ladite plaque froide (6) et ledit substrat (2) et ledit raccord en métal (10) est rempli avec un gaz prédéterminé choisi dans un groupe qui inclut l'azote et l'hélium.

3.  Structure de scellage de module selon la revendication 1 ou 2, caractérisé en ce que ledit substrat (2) comporte des motifs de circuit (50) formés sur sa seconde surface (2b) et ladite couche conductrice (12) est constituée par une couche de métal identique à une couche de métal qui constitue les motifs de circuit.

4.  Structure de scellage de module selon la revendication 3, caractérisé en ce qu'une couche isolante (15) est formée sur lesdits motifs de circuit (50) et ladite couche isolante est constituée par ladite couche de polyimide (15).

5.  Structure de scellage de module selon la revendication 4, caractérisé en ce que ledit substrat (2) comporte en outre des motifs d'entrée/sortie (12a) qui sont formés sur ladite couche isolante (15) et qui établissent une connexion auxdits motifs de circuit (50) via des trous formés dans ladite couche isolante, et des broches d'entrée/sortie (4) qui assurent la connexion des motifs de circuit.

6.  Structure de scellage de module selon l'une quelconque des revendications 1 à 5, caractérisé en ce que ledit substrat (2) est réalisé en céramique.

7.  Structure de scellage de module selon l'une quelconque des revendications 1 à 5, caractérisé en ce que ledit substrat (2) est un substrat en céramique multicouche.

8.  Structure de scellage de module selon l'une quelconque des revendications 1 à 5, caractérisé en ce que ledit substrat (2) est un substrat en vitrocéramique.

9.  Structure de scellage de module selon l'une quelconque des revendications 1 à 7, caractérisé en ce que ledit raccord en métal ((10) présente de façon générale une forme en anneau rectangulaire qui est en correspondance avec une forme dudit substrat (2).

## FIG. 1 *(PRIOR ART)*

## FIG.2 *(PRIOR ART)*

# FIG.3

# FIG.4

**FIG.5**

**FIG.7**

FIG.6 A

*2*

FIG.6 B

*50*

*2*

FIG.6 C

*15*

*2*

FIG.6 D

*15a*  *15b*  *15a*

*2*

FIG.6 E

*4*  *12a*  *12A*  *12*

*2*